# FASCICULE DE BREVET EUROPEEN

(11) **EP 2 898 542 B1**
(45) Date de publication et mention de la délivrance du brevet: **07.09.2016**
(21) Numéro de dépôt: 13774098.1
(22) Date de dépôt: 24.09.2013
(51) Int. Cl.: H01L 31/072, H01L 31/0747

(54) **CELLULE PHOTOVOLTAIQUE A HETEROJONCTION ET PROCEDE DE FABRICATION D'UNE TELLE CELLULE**
PV-ZELLE MIT EINEM HETEROÜBERGANG UND VERFAHREN ZUR HERSTELLUNG SOLCH EINER ZELLE
PHOTOVOLTAIC CELL HAVING A HETEROJUNCTION AND METHOD FOR MANUFACTURING SUCH A CELL

(30) Priorité: 24.09.2012 FR 1258942
(43) Date de publication de la demande: 29.07.2015
(73) Titulaire: Commissariat à l'Énergie Atomique et aux Énergies Alternatives, 75015 Paris (FR)
(72) Inventeur: BUCKLEY, Julien, F-38000 Grenoble (FR); MUR, Pierre, F-38920 Crolles (FR)
(74) Mandataire: Regimbeau
(86) Numéro de dépôt international: PCT/EP2013/069880
(87) Numéro de publication internationale: WO 2014/044871

(56) Documents cités:
- EP-A2- 2 385 561
- US-A1- 2012 055 547
- HOHEISEL R ET AL: "Experimental Analysis of Majority Carrier Transport Processes at Heterointerfaces in Photovoltaic Devices", IEEE JOURNAL OF PHOTOVOLTAICS, I E E E, US, vol. 2, no. 3, 1 juillet 2012 (2012-07-01) , pages 398-402, XP011460276, ISSN: 2156-3381, DOI: 10.1109/JPHOTOV.2012.2199080

## Description

### DOMAINE DE L'INVENTION

La présente invention concerne une cellule photovoltaïque à hétérojonction ainsi qu'un procédé de fabrication d'une telle cellule.

### ARRIERE PLAN DE L'INVENTION

Une cellule photovoltaïque à hétérojonction est formée d'un empilement de couches permettant de convertir directement les photons reçus en un signal électrique.

Une telle cellule peut comprendre un substrat semi-conducteur dopé, de préférence un substrat de silicium cristallin dopé n ou p et, de part et d'autre dudit substrat, deux couches semi-conductrices (par exemple en silicium amorphe ou microcristallin) dopées n et p, ou fortement dopées n+ et p+, l'une du même type électrique que le substrat et l'autre du type opposé.

L'hétérojonction est formée par le substrat et la couche dopée du type opposé, qui forme l'émetteur de la cellule photovoltaïque.

La cellule est destinée à être éclairée par la face comportant l'émetteur, dite face avant. Ladite face avant est généralement texturée et recouverte d'une couche antireflet afin de minimiser la réflexion du rayonnement solaire.

Sur la face arrière, la couche dopée du même type que celui du substrat forme un champ électrique répulsif arrière ou « Back Surface Field » (BSF) selon la terminologie anglo-saxonne.

Cette couche a pour fonction d'éloigner les porteurs minoritaires du substrat (c'est-à-dire les électrons si le substrat est dopé p et les trous si le substrat est dopé n), en vue d'éviter la recombinaison avec les contacts formés en face arrière.

L'absorption d'un photon par la cellule se traduit par la création d'une paire électron/trou qui, sous l'effet du champ électrique intrinsèque généré par l'hétérojonction, se dissocie de telle sorte que les porteurs minoritaires photogénérés se dirigent vers la région où ces porteurs sont majoritaires.

Ainsi, dans un substrat de type p, les électrons photogénérés sont dirigés vers l'émetteur de type n+ tandis que les trous sont dirigés vers la couche de champ répulsif arrière de type p+ ; dans un substrat de type n, les trous photogénérés sont dirigés vers l'émetteur de type p+ tandis que les électrons sont dirigés vers la couche de champ répulsif arrière de type n+.

Des contacts électriques sont formés sur la face avant et la face arrière de la cellule pour collecter lesdits porteurs photogénérés.

Pour éviter les recombinaisons aux interfaces et augmenter l'efficacité de la conversion, il est habituel d'intercaler une couche de passivation entre le substrat et chacune des couches dopées ou fortement dopées.

La couche de passivation est généralement un silicium amorphe intrinsèque ou un matériau diélectrique, tel qu'un oxyde ou un nitrure.

Ainsi, le document FR 2 955 702 divulgue une cellule photovoltaïque dans laquelle les couches de passivation avant et arrière sont en oxyde de silicium cristallin.

Cependant, les couches de passivation constituent une barrière de potentiel pour les porteurs et sont donc susceptibles de limiter le passage des porteurs photogénérés vers l'émetteur ou la couche de champ répulsif au niveau desquels ils doivent être collectés.

Le document EP 2 385 561 décrit une cellule photovoltaïque à hétérojonction dans laquelle les couches de passivation permettent en outre le passage des porteurs par effet tunnel.

De telles couches de passivation ne permettent cependant pas d'optimiser la collecte des porteurs à la fois du côté de l'émetteur et du côté de la couche de champ répulsif arrière.

La figure 1 est un schéma du diagramme de bande d'une cellule conforme au document EP 2 385 561.

Sous le diagramme est schématisée la structure de ladite cellule, qui comprend un substrat 1 de silicium dopé n, deux couches de passivation 2A et 2B d'oxyde de silicium (de formule générale SiOx), l'émetteur E comprenant une couche 3A de silicium amorphe dopé p+ de manière graduelle et le champ répulsif BSF comprenant une couche 3B de silicium amorphe dopé n+.

La bande de conduction et la bande de valence sont désignées respectivement par les signes de référence BC et BV.

Les électrons e- sont schématisés par des disques sombres tandis que les trous h+ sont représentés par des disques clairs.

Comme on peut le voir sur ce diagramme, du côté de l'émetteur E, la hauteur de barrière est plus grande pour les électrons (ΦEe) que pour les trous (ΦEh), de sorte que le passage des trous par effet tunnel à travers la couche de passivation 2A vers le collecteur de courant (non représenté) de l'émetteur est favorisé.

En revanche, du côté du champ répulsif BSF, la hauteur de barrière est également plus grande pour les électrons (ΦBe) que pour les trous (ΦBh), de sorte que le passage des trous vers le collecteur de courant (non représenté) du champ répulsif arrière est favorisé. Or, au niveau du champ répulsif arrière, ce sont les électrons que l'on cherche à collecter de manière privilégiée.

Un but de l'invention est donc de définir un choix optimal de matériaux pour les couches de passivation.

### BREVE DESCRIPTION DE L'INVENTION

A cet effet, il est proposé une cellule photovoltaïque à hétérojonction comprenant un substrat d'un matériau semi-conducteur dopé, dans laquelle :
- une première face principale dudit substrat est recouverte successivement d'une couche de passivation, d'une couche d'un matériau semi-conducteur dopé du type opposé à celui du substrat, formant l'émetteur de ladite cellule, et d'une électrode,
- la seconde face principale dudit substrat est recouverte successivement d'une couche de passivation, d'une couche d'un matériau semi-conducteur dopé du même type que le substrat, formant un champ répulsif pour les porteurs minoritaires du substrat, et d'une électrode.

Conformément à l'invention :
- le matériau de la couche de passivation côté émetteur est choisi pour présenter une barrière de potentiel plus basse pour les porteurs minoritaires photogénérés que pour les porteurs majoritaires du substrat, de sorte à favoriser le passage desdits porteurs minoritaires photogénérés du substrat vers l'émetteur, par rapport à celui des porteurs majoritaires, et
- le matériau de la couche de passivation côté champ répulsif est choisi pour présenter une barrière de potentiel plus basse pour les porteurs majoritaires photogénérés que pour les porteurs minoritaires du substrat, de sorte à favoriser le passage des porteurs majoritaires photogénérés du substrat vers la couche de champ répulsif, par rapport à celui des porteurs minoritaires.

De manière avantageuse, les couches formant l'émetteur et le champ répulsif sont fortement dopées.

Par « fortement dopée », on entend que la couche présente un niveau de dopage supérieur d'au moins un ordre de grandeur par rapport au niveau de dopage du substrat. On parle alors de dopage n+ ou p+ en cas de fort dopage au lieu de n ou p en cas de dopage du même ordre de grandeur que celui du substrat.

A titre d'exemple, une couche dite « fortement dopée » peut présenter un dopage avec une concentration de dopants supérieure à 10¹⁷ at.cm⁻³.

Le substrat peut présenter en particulier une résistivité comprise entre 0,5 et 10 Ω.cm.

Selon une forme d'exécution de l'invention, le substrat est en silicium cristallin dopé de type n et les couches dopées respectivement de type p ou p+ et de type n ou n+ sont en silicium amorphe ou micro-cristallin.

Dans ce cas, le matériau de la couche de passivation côté émetteur est avantageusement choisi parmi un silicate de hafnium nitruré et un nitrure de silicium, et le matériau de la couche de passivation côté champ répulsif est avantageusement choisi parmi un oxyde de silicium et un oxyde de tantale.

Selon une forme d'exécution alternative, le substrat est en silicium cristallin dopé de type p et les couches dopées respectivement de type n ou n+ et de type p ou p+ sont en silicium amorphe ou micro-cristallin.

Dans ce cas, le matériau de la couche de passivation côté émetteur est avantageusement choisi parmi un oxyde de silicium et un oxyde de tantale, et le matériau de la couche de passivation côté champ répulsif est avantageusement choisi parmi un silicate de hafnium nitruré et un nitrure de silicium.

De préférence, l'épaisseur desdites couches de passivation est comprise entre 0,1 nm et 5 nm et encore préférentiellement comprise entre 0,1 nm et environ 1 nm.

Selon un mode de réalisation particulier de l'invention, ladite cellule comprend en outre, entre chaque couche de passivation et la couche de silicium amorphe ou micro-cristallin dopé, une couche de silicium amorphe intrinsèque.

De manière particulièrement avantageuse, au moins une face de ladite cellule est texturée.

Un autre objet de l'invention concerne un procédé de fabrication d'une telle cellule.

Ledit procédé comprend les étapes suivantes :
(a) formation, sur la première face principale du substrat, d'une couche de passivation en un matériau choisi pour présenter une barrière de potentiel plus basse pour les porteurs minoritaires photogénérés que pour les porteurs majoritaires du substrat, de sorte à favoriser le passage desdits porteurs minoritaires photogénérés du substrat vers l'émetteur, par rapport à celui des porteurs majoritaires,
(b) formation, sur la seconde face principale dudit substrat, d'une couche de passivation en un matériau choisi pour présenter une barrière de potentiel plus basse pour les porteurs majoritaires photogénérés que pour les porteurs minoritaires du substrat, de sorte à favoriser le passage desdits porteurs majoritaires photogénérés du substrat vers la couche de champ répulsif, par rapport à celui des porteurs minoritaires.

Selon une forme de mise en oeuvre dudit procédé, le substrat est en silicium cristallin dopé de type n et les couches dopées respectivement de type p ou p+ et de type n ou n+ sont en silicium amorphe ou micro-cristallin.

Dans ce cas, la couche de passivation côté émetteur peut être en silicate de hafnium nitruré, ladite couche étant avantageusement formée par dépôt, sur la première face principale du substrat, d'une couche de silicate d'hafnium suivi de la nitruration de ladite couche.

Par ailleurs, la couche de passivation côté champ répulsif peut être en oxyde de silicium, ladite couche étant formée par oxydation plasma du substrat.

Selon une autre forme de mise en oeuvre du procédé, le substrat est en silicium cristallin dopé de type p et les couches dopées respectivement de type n+ et de type p+ sont en silicium amorphe ou micro-cristallin.

Dans ce cas, la couche de passivation côté champ répulsif (BSF) est avantageusement en silicate de hafnium nitruré, ladite couche étant formée par dépôt, sur la seconde face principale du substrat, d'une couche de silicate de hafnium suivi de la nitruration de ladite couche.

Par ailleurs, la couche de passivation côté émetteur peut être en oxyde de silicium, ladite couche étant formée par oxydation plasma du substrat.

De préférence, l'épaisseur desdites couches de passivation est comprise entre 0,1 nm et 5 nm, et de manière encore préférée comprise entre 0,1 et environ 1 nm.

### BREVE DESCRIPTION DES DESSINS

D'autres caractéristiques et avantages de l'invention ressortiront de la description détaillée qui va suivre, en référence aux dessins annexés sur lesquels :
- la figure 1 est un schéma du diagramme de bande d'une cellule selon l'art antérieur (EP 2 385 561),
- la figure 2 est un schéma d'une cellule photovoltaïque selon un mode de réalisation de l'invention,
- la figure 3 est un schéma du diagramme de bande d'une cellule selon un mode de réalisation de l'invention, le substrat étant en silicium dopé de type n,
- la figure 4 est un schéma du diagramme de bande d'une cellule qui, contrairement à l'invention, comprend des couches de passivation réalisées dans le même matériau du côté de l'émetteur et du côté de la couche de champ répulsif arrière, le substrat étant en silicium dopé de type n.

### DESCRIPTION DETAILLEE DE MODES DE REALISATION DE L'INVENTION

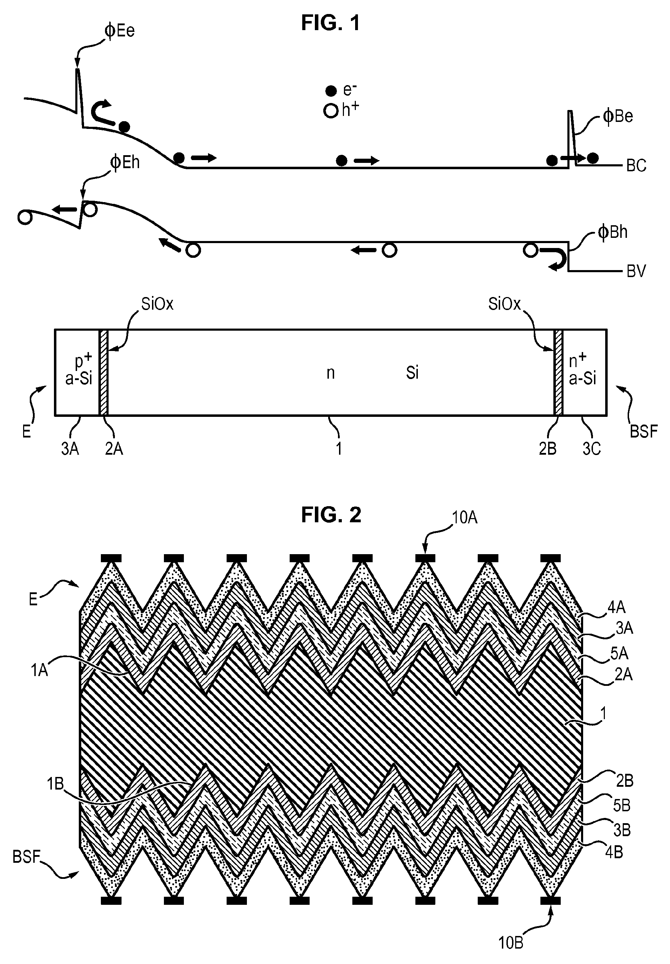

La figure 2 est une vue en coupe d'une cellule photovoltaïque selon un mode de réalisation de l'invention.

La cellule comprend un substrat 1 qui est en un matériau semi-conducteur dopé, par exemple du silicium cristallin dopé.

De manière alternative, ledit substrat peut également être en un autre matériau semi-conducteur, par exemple Ge, InGaN, GaAs (liste non limitative).

De manière avantageuse, la face de la cellule destinée à recevoir le rayonnement solaire est texturée afin de minimiser les réflexions.

Dans l'exemple illustré sur la figure 2, les deux faces de la cellule sont texturées, la texture se présentant sous la forme de pyramides adjacentes. Néanmoins, il va de soi qu'aucune ou une seule des faces pourrait être texturée, et que la texture pourrait se présenter sous une forme différente, sans pour autant sortir du cadre de l'invention.

L'émetteur E de la cellule est formé sur une première face principale 1A dudit substrat.

A cet effet, on recouvre ladite face 1A successivement d'une couche de passivation 2A, d'une couche 3A d'un matériau semi-conducteur dopé ou fortement dopé du type opposé à celui du substrat 1, formant avec le substrat 1 l'hétérojonction, et d'une électrode 4A.

La couche de passivation 2A est formée directement sur la première face principale 1A du substrat 1, sans qu'une couche d'un autre matériau ne soit intercalée entre le substrat et ladite couche 2A.

La couche 2A étant en un matériau diélectrique, elle a pour effet de passiver la face 1A du substrat 1.

Afin d'assurer une passivation de bonne qualité, une oxydation et/ou hydrogénation radicalaire de la surface du substrat en silicium peut être mise en oeuvre au préalable.

Le matériau semi-conducteur de la couche 3A est avantageusement du silicium amorphe ou micro-cristallin.

Ladite électrode 4A est typiquement en oxyde d'indium et d'étain (ITO), qui est transparent au rayonnement solaire.

Sur l'électrode 4A est formé un collecteur de courant 10A qui se présente, dans le mode de réalisation illustré, sous la forme d'un peigne métallique.

De manière optionnelle, une couche 5A de silicium amorphe intrinsèque (c'est-à-dire non intentionnellement dopé) peut être intercalée entre la couche de passivation 2A et la couche dopée 3A.

Ladite couche 5A peut permettre d'améliorer la passivation côté émetteur, en complément de la couche de passivation 2A.

Par ailleurs, la couche de champ répulsif BSF est formée sur la seconde face principale 1 B du substrat.

A cet effet, on recouvre la seconde face principale 1 B du substrat successivement d'une couche de passivation 2B, d'une couche 3B d'un matériau semi-conducteur dopé ou fortement dopé du même type que le substrat, formant un champ répulsif BSF pour les porteurs minoritaires du substrat, et d'une électrode 4B.

La couche de passivation 2B est formée directement sur la première face principale 1A du substrat 1, sans qu'une couche d'un autre matériau ne soit intercalée entre le substrat et ladite couche 2A.

La couche 2B étant en un matériau diélectrique, elle a pour effet de passiver la face 1 B du substrat 1.

Le matériau semi-conducteur de la couche 3B est avantageusement du silicium amorphe ou micro-cristallin.

Ladite électrode 4B est, par exemple, en oxyde d'indium et d'étain (ITO).

Sur l'électrode 4B est formé un collecteur de courant 10B qui se présente, dans le mode de réalisation illustré, sous la forme d'un peigne métallique.

De manière optionnelle, une couche 5B de silicium amorphe intrinsèque peut être intercalée entre la couche de passivation 2B et la couche dopée 3B.

Ladite couche 5B peut permettre d'améliorer la passivation côté champ répulsif arrière, en complément de la couche de passivation 2B.

Les différentes couches mentionnées ci-dessus sont déposées sur chacune des faces du substrat 1 selon des procédés bien connus de l'homme du métier.

Ces couches sont déposées de manière conforme, c'est-à-dire qu'elles présentent une épaisseur constante en tout point de la surface de la cellule. Elles reproduisent ainsi le relief procuré par la texture de la face du substrat sur laquelle elles sont déposées.

Lesdites couches peuvent être formées simultanément sur les deux faces du substrat, ou bien successivement sur une face puis sur l'autre.

Contrairement aux cellules photovoltaïques connues, la couche de passivation 2A formée du côté de l'émetteur et la couche de passivation 2B formée du côté de la couche de champ répulsif arrière ne sont pas réalisées dans le même matériau.

En effet, chacune des couches de passivation 2A et 2B est en un matériau choisi pour permettre de collecter, respectivement à l'émetteur et à la couche de champ répulsif arrière, un maximum de porteurs photogénérés par rapport aux porteurs non photogénérés.

Selon le type de dopage du substrat, on définit ainsi des couples de matériaux différents pour la couche de passivation 2A côté émetteur et pour la couche de passivation 2B côté champ répulsif.

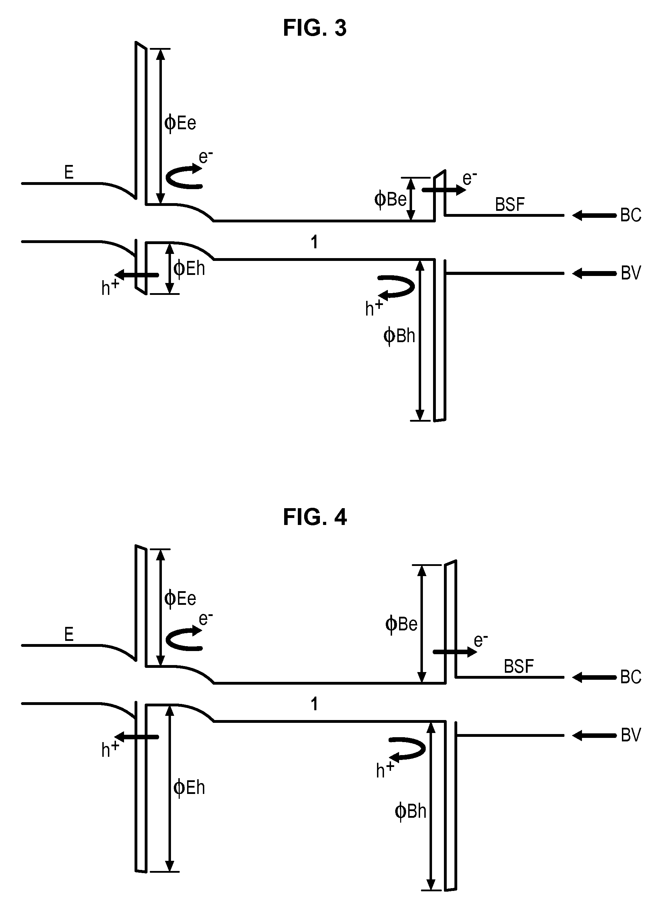

La figure 3 illustre un diagramme de bande d'une telle cellule pour un substrat de type n. Les porteurs photogénérés (électrons e- et trous h+ sont représentés respectivement sur la bande de conduction BC et sur la bande de valence BV).

On rappelle que dans un substrat de type n, les trous photogénérés (qui correspondent aux porteurs minoritaires) sont dirigés vers l'émetteur de type p+ tandis que les électrons photogénérés (qui correspondent aux porteurs majoritaires) sont dirigés vers la couche de champ répulsif arrière de type n+.

Sur le diagramme de la figure 3 sont représentées les grandeurs suivantes :
ΦEe : hauteur de barrière pour les électrons au niveau de l'émetteur E ;
ΦBe : hauteur de barrière pour les électrons au niveau du champ répulsif arrière BSF;
ΦEh : hauteur de barrière pour les trous au niveau de l'émetteur ;
ΦBh : hauteur de barrière pour les trous au niveau du champ répulsif arrière.

Comme on peut le voir sur la figure 3, du côté de l'émetteur E, la hauteur de barrière ΦEe générée par la couche de passivation 2A est supérieure à la hauteur de barrière ΦEh, ce qui se traduit par le fait que le passage des trous photogénérés vers le collecteur de courant 10A est favorisé par rapport à celui des électrons (porteurs non photogénérés).

En revanche, du côté du champ répulsif arrière BSF, la hauteur de barrière ΦBe générée par la couche de passivation 2B est inférieure à la hauteur de barrière ΦBh, ce qui se traduit par le fait que le passage des électrons photogénérés vers le collecteur de courant 10B est favorisé par rapport à celui des trous (porteurs non photogénérés).

Inversement, lorsque le substrat est de type p, les électrons photogénérés (qui correspondent aux porteurs minoritaires) sont dirigés vers l'émetteur de type n+ tandis que les trous photogénérés (qui correspondent aux porteurs majoritaires) sont dirigés vers la couche de champ répulsif arrière de type p.

Dans ce cas, on choisit les matériaux des couches de passivation de la manière suivante :
- du côté de l'émetteur, on choisit une couche de passivation qui génère une hauteur de barrière ΦEe inférieure à la hauteur de barrière ΦEh, de sorte à favoriser le passage des électrons photogénérés par rapport à celui des trous vers le collecteur de courant 10A;
- du côté du champ répulsif, on choisit une couche de passivation qui génère une hauteur de barrière ΦBe supérieure à la hauteur de barrière ΦBh, de sorte à favoriser le passage des trous photogénérés par rapport à celui des électrons vers le collecteur de courant 10B.

Le tableau ci-dessous fournit quelques exemples de couples de matériaux appropriés selon le type de dopage du substrat.

| Type de dopage du substrat | Couche de passivation côté émetteur | Couche de passivation côté champ répulsif |
|---|---|---|
| n | HfSiON | SiO₂ |
| n | SiN | SiO₂ |
| n | SiN | Ta₂O₅ |
| n | HfSiON | Ta₂O₅ |
| p | SiO₂ | HfSiON |
| p | SiO₂ | SiN |
| p | Ta₂O₅ | HfSiON |
| p | Ta₂O₅ | SiN |

Dans le cas où le substrat n'est pas en silicium mais en un autre matériau semi-conducteur, les couples de matériaux indiqués dans le tableau ci-dessus peuvent être utilisés, à l'exception des couples de matériaux comprenant de l'oxyde de silicium.

On précise que la notation employée pour les différents matériaux envisagés ne vise pas à spécifier une composition chimique précise incluant la stoechiométrie des différents éléments, mais à indiquer une famille de matériaux contenant les éléments mentionnés.

Selon un mode de réalisation où le substrat 1 est de type n, la couche de passivation 2A (côté émetteur) est réalisée en silicate de hafnium nitruré (également noté HfSiON) et la couche de passivation 2B (côté champ répulsif) est réalisée en oxyde de silicium (également noté SiO₂ ou plus généralement SiOₓ).

Le HfSiON présente une hauteur de barrière par rapport au silicium d'environ 1,6 eV pour les trous et 2,1 eV pour les électrons [Barrett06].

L'optimisation du procédé de passivation par une couche de HfSiON a été décrite dans [O'Connor09].

La couche 2A peut être réalisée par dépôt chimique en phase vapeur (CVD) d'une couche de silicate de hafnium (noté HfSiO₂) suivi d'une nitruration de ladite couche à 750°C par NH₃.

L'épaisseur de ladite couche est typiquement comprise entre 0,1 et 5 nm et avantageusement inférieur ou égale à 1 nm.

Le SiOₓ présente une hauteur de barrière par rapport au silicium d'environ 3 eV pour les électrons et supérieure à 4 eV pour les trous [Gritsenko03].

La couche 2B peut être réalisée par oxydation plasma de la face 1 B du substrat 1, permettant d'obtenir une couche en oxyde de silicium d'une épaisseur de 1 nm environ.

Selon un mode de réalisation alternatif dans lequel le substrat 1 est également de type n, la couche de passivation 2A (côté émetteur) est réalisée en nitrure de silicium (SiN) et la couche de passivation 2B (côté champ répulsif) est réalisée en SiO₂.

Le SiN présente une hauteur de barrière par rapport au silicium d'environ 1,5 eV pour les trous et 2 eV pour les électrons [Gritsenko03].

Ladite couche de SiN est avantageusement formée par un dépôt chimique en phase vapeur.

Selon un mode de réalisation où le substrat 1 est de type p, la couche de passivation 2A (côté émetteur) est réalisée en SiO₂ et la couche de passivation 2B (côté champ répulsif) est réalisée en HfSiON.

Selon un mode de réalisation alternatif où le substrat 1 est également de type p, la couche de passivation 2A (côté émetteur) est réalisée en SiO₂ et la couche de passivation 2B (côté champ répulsif) est réalisée en SiN.

A titre de comparaison avec le diagramme de bande de la figure 3, qui correspondait à une cellule conforme à un mode de réalisation de l'invention, la figure 4 présente le diagramme de bande d'une cellule présentant un empilement de couches similaire à celui de la figure 2 mais dans laquelle, contrairement à l'invention, les couches de passivation côté émetteur et côté champ répulsif sont toutes deux en oxyde de silicium (SiOx).

On observe donc que les hauteurs de barrière ΦEe, ΦBe pour les électrons sont plus grandes que pour les hauteurs de barrière ΦEh, ΦBh pour les trous.

Ceci implique que, selon le type de substrat, pour l'un des côtés de la cellule (émetteur ou champ répulsif arrière), le passage des porteurs photogénérés que l'on cherche à collecter est défavorisé par rapport à celui des porteurs non photogénérés.

### REFERENCES

FR 2 955 702
EP 2 385 561
[Barrett06] "Band offsets of nitrided ultrathin hafnium silicate films", N. T. Barrett, O. Renault, P. Besson, Y. Le Tiec, and F. Martin, APL 88, 162906, 2006
[Gritsenlo03] "Valence band offset at siliconysilicon nitride and silicon nitrideysilicon oxide interfaces", Vladimir A. Gritsenko, Alexandr V. Shaposhnikov, W.M. Kwokb, Hei Wongc, Georgii M. Jidomirov, Thin Solid Films 437 (2003) 135-139
[O'Connor09] "The Role of Nitrogen in HfSiON Defect Passivation", R. O'Connor, M. Aoulaiche, L. Pantisano, A. Shickova, R. Degraeve, B. Kaczer, G. Groeseneken, International Reliability Physics Symposium, pp. 921-924, 2009.

## Revendications

1. Cellule photovoltaïque à hétérojonction comprenant un substrat (1) d'un matériau semi-conducteur dopé, dans laquelle :
- une première face principale (1A) dudit substrat (1) est recouverte successivement d'une couche de passivation (2A), d'une couche (3A) d'un matériau semi-conducteur dopé du type opposé à celui du substrat (1), formant l'émetteur de ladite cellule, et d'une électrode (4A),
- la seconde face principale (1 B) dudit substrat est recouverte successivement d'une couche de passivation (2B), d'une couche (3B) d'un matériau semi-conducteur dopé du même type que le substrat, formant un champ répulsif (BSF) pour les porteurs minoritaires du substrat, et d'une électrode (4B),
ladite cellule étant **caractérisée en ce que** :
- le matériau de la couche de passivation (2A) côté émetteur (E) est choisi pour présenter une barrière de potentiel plus basse pour les porteurs minoritaires photogénérés que pour les porteurs majoritaires du substrat, de sorte à favoriser le passage desdits porteurs minoritaires photogénérés du substrat (1) vers l'émetteur (3A), par rapport à celui des porteurs majoritaires, et
- le matériau de la couche de passivation (2B) côté champ répulsif (BSF) est choisi pour présenter une barrière de potentiel plus basse pour les porteurs majoritaires photogénérés que pour les porteurs minoritaires du substrat, de sorte à favoriser le passage des porteurs majoritaires photogénérés du substrat (1) vers la couche de champ répulsif (3B), par rapport à celui des porteurs minoritaires.

2. Cellule photovoltaïque selon la revendication 1, **caractérisée en ce que** le substrat (1) est en silicium cristallin dopé de type n et **en ce que** les couches (3A, 3B) dopées respectivement de type p ou p+ et de type n ou n+ sont en silicium amorphe ou micro-cristallin.

3. Cellule photovoltaïque selon la revendication 2, **caractérisée en ce que** :
- le matériau de la couche de passivation (2A) côté émetteur est choisi parmi un silicate de hafnium nitruré et un nitrure de silicium, et
- le matériau de la couche de passivation (2B) côté champ répulsif est choisi parmi un oxyde de silicium et un oxyde de tantale.

4. Cellule photovoltaïque selon la revendication 1, **caractérisée en ce que** le substrat (1) est en silicium cristallin dopé de type p et **en ce que** les couches (3A, 3B) dopées respectivement de type n ou n+ et de type p ou p+ sont en silicium amorphe ou micro-cristallin.

5. Cellule photovoltaïque selon la revendication 4, **caractérisée en ce que** :
- le matériau de la couche de passivation (2A) côté émetteur est choisi parmi un oxyde de silicium et un oxyde de tantale, et
- le matériau de la couche de passivation (2B) côté champ répulsif est choisi parmi un silicate de hafnium nitruré et un nitrure de silicium.

6. Cellule photovoltaïque selon l'une des revendications 1 à 5, **caractérisée en ce que** l'épaisseur desdites couches de passivation (2A, 2B) est comprise entre 0,1 nm et 5 nm et préférentiellement comprise entre 0,1 nm et environ 1 nm.

7. Cellule photovoltaïque selon l'une des revendications 2 à 5, **caractérisée en ce qu'**elle comprend, entre chaque couche de passivation (2A, 2B) et la couche (3A, 3B) de silicium amorphe ou micro-cristallin dopé, une couche (5A, 5B) de silicium amorphe intrinsèque.

8. Cellule photovoltaïque selon l'une des revendications 1 à 7, **caractérisée en ce qu'**au moins une face de ladite cellule est texturée.

9. Procédé de fabrication d'une cellule photovoltaïque à hétérojonction comprenant un substrat (1) d'un matériau semi-conducteur dopé, dans laquelle :
- une première face principale (1A) dudit substrat (1) est recouverte successivement d'une couche de passivation (2A), d'une couche (3A) d'un matériau semi-conducteur dopé du type opposé à celui du substrat (1), formant l'émetteur (E) de ladite cellule, et d'une électrode (4A),
- la seconde face principale (1 B) dudit substrat (1) est recouverte successivement d'une couche de passivation (2B), d'une couche (3B) d'un matériau semi-conducteur dopé du même type que le substrat (1), formant un champ répulsif (BSF) pour les porteurs minoritaires du substrat, et d'une électrode (4B),
ledit procédé étant **caractérisé en ce qu'**il comprend les étapes suivantes :
(a) formation, sur la première face principale (1A) dudit substrat, d'une couche de passivation (2A) en un matériau choisi pour présenter une barrière de potentiel plus basse pour les porteurs minoritaires photogénérés que pour les porteurs majoritaires du substrat, de sorte à favoriser le passage desdits porteurs minoritaires photogénérés du substrat (1) vers l'émetteur (E), par rapport à celui des porteurs majoritaires,
(b) formation, sur la seconde face principale (1 B) dudit substrat, d'une couche de passivation (2B) en un matériau choisi pour présenter une barrière de potentiel plus basse pour les porteurs majoritaires photogénérés que pour les porteurs minoritaires du substrat, de sorte à favoriser le passage desdits porteurs majoritaires photogénérés du substrat (1) vers la couche de champ répulsif (3B), par rapport à celui des porteurs minoritaires.

10. Procédé selon la revendication 9, **caractérisé en ce que** le substrat (1) est en silicium cristallin dopé de type n et **en ce que** les couches (3A, 3B) dopées respectivement de type p ou p+ et de type n ou n+ sont en silicium amorphe ou micro-cristallin.

11. Procédé selon la revendication 10, **caractérisé en ce que** la couche de passivation (2A) côté émetteur est en silicate de hafnium nitruré et **en ce que** ladite couche (2A) est formée par dépôt, sur la première face principale (1A) du substrat, d'une couche de silicate d'hafnium suivi de la nitruration de ladite couche.

12. Procédé selon l'une des revendications 10 ou 11, **caractérisé en ce que** la couche de passivation (2B) côté champ répulsif est en oxyde de silicium , ladite couche étant formée par oxydation plasma du substrat (1).

13. Procédé selon la revendication 9, **caractérisé en ce que** le substrat (1) est en silicium cristallin dopé de type p et **en ce que** les couches (3A, 3B) dopées respectivement de type n+ et de type p+ sont en silicium amorphe ou micro-cristallin.

14. Procédé selon la revendication 13, **caractérisé en ce que** la couche de passivation (2B) côté champ répulsif (BSF) est en silicate de hafnium nitruré et **en ce que** ladite couche (2B) est formée par dépôt, sur la seconde face principale (1 B) du substrat, d'une couche de silicate de hafnium suivi de la nitruration de ladite couche.

15. Procédé selon l'une des revendications 13 ou 14, **caractérisé en ce que** la couche de passivation (2A) côté émetteur est en oxyde de silicium, ladite couche étant formée par oxydation plasma du substrat (1).

## Patentansprüche

1. Photovoltaik-Zelle mit Heteroübergang, umfassend ein Substrat (1) eines dotierten Halbleitermaterials, wobei:
- eine erste Hauptfläche (1A) des Substrats (1) aufeinanderfolgend mit einer Passivationsschicht (2A), einer Schicht (3A) eines dotieren Halbleitermaterials entgegengesetzten Typs zu dem des Substrats (1), die den Sender der Zelle bildet, und einer Elektrode (4A) bedeckt ist,
- die zweite Hauptfläche (1B) des Substrats aufeinanderfolgend mit einer Passivationsschicht (2B), einer Schicht (3B) eines dotierten Halbleitermaterials desselben Typs wie das Substrat, die ein repulsives Feld (BSF) für die minoritären Träger des Substrats bildet, und einer Elektrode (4B) bedeckt ist,
wobei die Zelle **dadurch gekennzeichnet ist, dass**:
- das Material der Passivationsschicht (2A) auf der Senderseite (E) ausgewählt ist, um für die photogenerierten minoritären Träger eine niedrigere Potentialbarriere darzustellen als für die majoritären Träger des Substrats, so dass der Übergang der photogenerierten minoritären Träger des Substrats (1) zum Sender (3A) im Vergleich zu dem der majoritären Träger gefördert wird, und
- das Material der Passivationsschicht (2B) auf der Seite des repulsiven Felds (BSF) ausgewählt ist, um für die photogenerierten majoritären Träger eine niedrigere Potentialbarriere darzustellen als für die minoritären Träger des Substrats, so dass der Übergang der photogenerierten majoritären Träger des Substrats (1) zur repulsiven Feldschicht (3B) im Vergleich zu dem der minoritären Träger gefördert wird.

2. Photovoltaik-Zelle nach Anspruch 1, **dadurch gekennzeichnet, dass** das Substrat (1) aus dotiertem kristallinem Silizium vom Typ n ist und dass die dotierten Schichten (3A, 3B) jeweils des Typs p oder p+ und des Typs n oder n+ aus amorphem oder mikrokristallinem Silizium sind.

3. Photovoltaik-Zelle nach Anspruch 2, **dadurch gekennzeichnet, dass**:
- das Material der Passivationsschicht (2B) auf der Senderseite aus einem Hafniumnitridsilikat und einem Siliziumnitrid ausgewählt ist, und
- das Material der Passivationsschicht (2B) auf der Seite des repulsiven Felds aus einem Siliziumoxid und einem Tantaloxid ausgewählt ist.

4. Photovoltaik-Zelle nach Anspruch 1, **dadurch gekennzeichnet, dass** das Substrat (1) aus dotiertem kristallinem Silizium des Typs p ist und dass die dotierten Schichten (3A, 3B) jeweils des Typs n oder n+ und des Typs p oder p+ aus amorphem oder mikrokristallinem Silizium sind.

5. Photovoltaik-Zelle nach Anspruch 4, **dadurch gekennzeichnet, dass** :
- das Material der Passivationsschicht (2A) auf der Senderseite aus einem Siliziumoxid und einem Tantaloxid ausgewählt ist, und
- das Material der Passivationsschicht (2B) auf der Seite des repulsiven Felds aus einem Hafniumnitridsilikat und einem Siliziumnitrid ausgewählt ist.

6. Photovoltaik-Zelle nach einem der Ansprüche 1 bis 5, **dadurch gekennzeichnet, dass** die Dicke der Passivationsschichten (2A, 2B) zwischen 0,1 nm und 5 nm inklusive und vorzugsweise zwischen 0,1 nm und zirka 1 nm inklusive ist.

7. Photovoltaik-Zelle nach einem der Ansprüche 2 bis 5, **dadurch gekennzeichnet, dass** sie zwischen jeder Passivationsschicht (2A, 2B) und der Schicht (3A, 3B) dotierten amorphen oder mikrokristallinen Siliziums eine Schicht (5A, 5B) eigenleitenden amorphen Siliziums umfasst.

8. Photovoltaik-Zelle nach einem der Ansprüche 1 bis 7, **dadurch gekennzeichnet, dass** zumindest eine Fläche der Zelle texturiert ist.

9. Herstellungsverfahren einer Photovoltaik-Zelle mit Heteroübergang, umfassend ein Substrat (1) eines dotierten Halbleitermaterials, wobei:
- eine erste Hauptfläche (1A) des Substrats (1) aufeinanderfolgend mit einer Passivationsschicht (2A), einer Schicht (3A) eines dotieren Halbleitermaterials entgegengesetzten Typs zu dem des Substrats (1), die den Sender der Zelle bildet, und einer Elektrode (4A) bedeckt wird,
- die zweite Hauptfläche (1B) des Substrats (1) aufeinanderfolgend mit einer Passivationsschicht (2B), einer Schicht (3B) eines dotierten Halbleitermaterials desselben Typs wie das Substrat (1), die ein repulsives Feld (BSF) für die minoritären Träger des Substrats bildet, und einer Elektrode (4B) bedeckt wird,
wobei das Verfahren **dadurch gekennzeichnet ist, dass** es die folgenden Schritte umfasst:
(a) Bilden, auf der ersten Hauptfläche (1A) des Substrats, einer Passivationsschicht (2A) aus einem Material, das ausgewählt ist, um für die photogenerierten minoritären Träger eine niedrigere Potentialbarriere darzustellen als für die majoritären Träger des Substrats, so dass der Übergang der photogenerierten minoritären Träger des Substrats (1) zum Sender (E) im Vergleich zu dem der majoritären Träger gefördert wird, und
(b) Bilden, auf der zweiten Hauptfläche (1B) des Substrats, einer Passivationsschicht (2B) aus einem Material, das ausgewählt ist, um für die photogenerierten majoritären Träger eine niedrigere Potentialbarriere darzustellen als für die minoritären Träger des Substrats, so dass der Übergang der photogenerierten majoritären Träger des Substrats (1) zur repulsiven Feldschicht (3B) im Vergleich zu dem der minoritären Träger gefördert wird.

10. Verfahren nach Anspruch 9, **dadurch gekennzeichnet, dass** das Substrat (1) aus dotiertem kristallinem Silizium des Typs n ist und das die dotierten Schichten (3A, 3B) jeweils des Typs p oder p+ und des Typs n oder n+ aus amorphem oder mikrokristallinem Silizium sind.

11. Verfahren nach Anspruch 10, **dadurch gekennzeichnet, dass** die Passivationsschicht (2A) auf der Senderseite aus Hafniumnitridsilikat ist und dass die Schicht (2A) durch Aufbringen einer Hafniumsilikatschicht auf die erste Hauptfläche (1A) des Substrats, gefolgt von einer Nitrierung der Schicht, gebildet wird.

12. Verfahren nach einem der Ansprüche 10 oder 11, **dadurch gekennzeichnet, dass** die Passivationsschicht (2B) auf der Seite des repulsiven Felds aus Siliziumoxid ist, wobei die Schicht durch Plasmaoxidation des Substrats (1) gebildet wird.

13. Verfahren nach Anspruch 9, **dadurch gekennzeichnet, dass** das Substrat (1) aus dotiertem kristallinem Silizium des Typs p ist und dass die dotierten Schichten (3A, 3B) jeweils des Typs n+ und des Typs p+ aus amorphem oder mikrokristallinem Silizium sind.

14. Verfahren nach Anspruch 13, **dadurch gekennzeichnet, dass** die Passivationsschicht (2B) auf der Seite des repulsiven Felds (BSF) aus Hafniumnitridsilikat ist und dass die Schicht (2B) durch Aufbringen einer Hafniumsilikatschicht auf die zweite Hauptfläche (1B) des Substrats, gefolgt von einer Nitrierung der Schicht, gebildet wird.

15. Verfahren nach einem der Ansprüche 13 oder 14, **dadurch gekennzeichnet, dass** die Passivationsschicht (2A) auf der Senderseite aus Siliziumoxid ist, wobei die Schicht durch Plasmaoxidation des Substrat (1) gebildet wird.

## Claims

1. A heterojunction photovoltaic cell comprising a substrate (1) in doped semiconductor material, wherein:
- a first main surface (1A) of said substrate (1) is successively coated with a passivation layer (2A), a layer (3A) of semiconductor material having opposite type doping to the substrate (1) and forming the emitter of said cell, and an electrode (4A),
- the second main surface (1 B) of said substrate is successively coated with a passivation layer (2B), a layer (3B) of semiconductor material having same type doping as the substrate and forming a back surface field (BSF) for the minority carriers of the substrate, and an electrode (4B),
said cell being **characterized in that**:
- the material of the passivation layer (2A) on the emitter side (E) is selected to have a lower potential barrier for the photogenerated minority carriers than for the majority carriers of the substrate, so as to promote the passing of said photogenerated minority carriers from the substrate (1) towards the emitter (3A) in relation to the passing of the majority carriers; and
- the material of the passivation layer (2B) on the side of the back surface field (BSF) is selected to have a lower potential barrier for the photogenerated majority carriers than for the minority carriers of the substrate, so as to promote the passing of the photogenerated majority carriers from the substrate (1) towards the back surface field layer (3B) in relation to the passing of the minority carriers.

2. The photovoltaic cell according to claim 1, **characterized in that** the substrate (1) is in n-doped crystalline silicon and **in that** the doped layers (3A, 3B) respectively of p or p+ type and of n or n+ type are in amorphous or microcrystalline silicon.

3. The photovoltaic cell according to claim 2, **characterized in that**:
- the material of the passivation layer (2A) on the emitter side is selected from nitrided hafnium silicate and silicon nitride; and
- the material of the passivation layer (2B) on the back surface field side is selected from silicon oxide and tantalum oxide.

4. The photovoltaic cell according to claim 1, **characterized in that** the substrate (1) is in p-doped crystalline silicon and **in that** the doped layers (3A, 3B) respectively of n or n+ type and p or p+ type are in amorphous or microcrystalline silicon.

5. The photovoltaic cell according to claim 4, **characterized in that**:
- the material of the passivation layer (2A) on the emitter side is selected from silicon oxide and tantalum oxide; and
- the material of the passivation layer (2B) on the back surface field side is selected from nitrided hafnium silicate and silicon nitride.

6. The photovoltaic cell according to one of claims 1 to 5, **characterized in that** the thickness of said passivation layers (2A, 2B) is between 0.1 nm and 5 nm and is preferably between 0.1 nm and about 1 nm.

7. The photovoltaic cell according to one of claims 2 to 5 **characterized in that**, between each passivation layer (2A, 2B) and the layer (3A, 3B) of doped amorphous or microcrystalline silicon, it comprises a layer (5A, 5B) of intrinsic amorphous silicon.

8. The photovoltaic cell according to one of claims 1 to 7, **characterized in that** at least one surface of said cell is texturized.

9. A method for manufacturing a heterojunction photovoltaic cell comprising a substrate (1) in doped semiconductor material, wherein:
- a first main surface (1A) of said substrate (1) is successively coated with a passivation layer (2A), a layer (3A) in semiconductor material having opposite type doping to the substrate (1) and forming the emitter (E) of said cell, and an electrode (4A),
- the second main surface (1 B) of said substrate (1) is successively coated with a passivation layer (2B), a layer (3B) in semiconductor material having same type doping as the substrate (1) and forming a back surface field (BSF) for the minority carriers of the substrate, and an electrode (4B),
said method being **characterized in that** it comprises the following steps:
(a) forming, on the first main surface (1A) of said substrate, a passivation layer (2A) in a material selected to have a lower potential barrier for the photogenerated minority carriers than for the majority carriers of the substrate, so as to promote the passing of said photogenerated minority carriers from the substrate (1) towards the emitter (E) in relation to the passing of the majority carriers;
(b) forming, on the second main surface (1 B) of said substrate, a passivation layer (2B) in a material selected to have a lower potential barrier for the photogenerated majority carriers than for the minority carriers of the substrate, so as to promote the passing of said photogenerated majority carriers from the substrate (1) towards the back surface field layer (3B), in relation to the passing of the minority carriers.

10. The method according to claim 9, **characterized in that** the substrate (1) is in n-doped crystalline silicon and **in that** the layers (3A, 3B) respectively p or p+ doped and n or n+ doped are in amorphous or microcrystalline silicon.

11. The method according to claim 10, **characterized in that** the passivation layer (2A) on the emitter side is in nitrided hafnium silicate and **in that** said layer (2A) is formed by the depositing, on the first main surface (1A) of the substrate, of a layer of hafnium silicate followed by nitriding of said layer.

12. The method according to one of claims 10 or 11, **characterized in that** the passivation layer (2B) on the back surface field side is in silicon oxide, said layer being formed by plasma oxidation of the substrate (1).

13. The method according to claim 9, **characterized in that** the substrate (1) is in p-doped crystalline silicon and **in that** the layers (3A, 3B) respectively n+ and p+ doped are in amorphous or microcrystalline silicon.

14. The method according to claim 13, **characterized in that** the passivation layer (2B) on the side of the back surface field (BSF) is in nitrided hafnium silicate and **in that** said layer (2B) is formed by the depositing, on the second main surface (1B) of the substrate, of a layer of hafnium silicate followed by nitriding of said layer.

15. The method according to one of claims 13 or 14, **characterized in that** the passivation layer (2A) on the emitter side is in silicon oxide, said layer being formed by plasma oxidation of the substrate (1).
